Europäisches Patentamt

European Patent Office

Office européen des brevets

(11) Publication number : **0 508 821 A2**

# (12) EUROPEAN PATENT APPLICATION

(21) Application number : 92303245.2

(22) Date of filing : 10.04.92

(51) Int. Cl.$^5$ : **H01L 27/12, B32B 18/00, C04B 35/10, C04B 35/18, C04B 38/08**

(30) Priority : 12.04.91 JP 79457/91

(43) Date of publication of application :
**14.10.92 Bulletin 92/42**

(84) Designated Contracting States :
**DE FR GB**

(71) Applicant : **FUJITSU LIMITED**
**1015, Kamikodanaka Nakahara-ku**
**Kawasaki-shi Kanagawa 211 (JP)**

(72) Inventor : **Kamezaki, Hiroshi, c/o FUJITSU LIMITED**
**1015, Kamikodanaka, Nakahara-ku**
**Kawasaki-shi, Kanagawa 211 (JP)**
Inventor : **Wakamura, Masato, c/o FUJITSU LIMITED**
**1015, Kamikodanaka, Nakahara-ku**
**Kawasaki-shi, Kanagawa 211 (JP)**
Inventor : **Yokouchi, Kishio, c/o FUJITSU LIMITED**
**1015, Kamikodanaka, Nakahara-ku**
**Kawasaki-shi, Kanagawa 211 (JP)**
Inventor : **Kamehara, Nobuo, c/o FUJITSU LIMITED**
**1015, Kamikodanaka, Nakahara-ku**
**Kawasaki-shi, Kanagawa 211 (JP)**

(74) Representative : **Silverman, Warren et al**
**HASELTINE LAKE & CO. Hazlitt House 28**
**Southampton Buildings Chancery Lane**
**London WC2A 1AT (GB)**

(54) Process for manufacturing multi-layer glass ceramic substrate.

(57)   A process for manufacturing a multi-layer glass ceramic substrate comprises the steps of forming green sheets containing ceramic powder and glass powder as main ingredients, laminating the green sheets, and firing the laminated green sheets to form a multi-layer glass ceramic substrate. At least one green sheet contains porous glass powder as part of the glass powder component to control the shrinkage of the green sheets and prevent cracks or delamination. Such green sheets containing porous glass powder are preferably comprised by a signal layer which is made up of intermediate sheets of a laminate formed from the green sheets and having an interconnection layer formed on each thereof. The signal layer is sandwiched between upper and lower green sheets which contain ceramic powders and glass powders and constitute the remainder of the laminate.

EP 0 508 821 A2

This invention relates to a process for manufacturing a multi-layer glass ceramic substrate, in which the firing shrinkage factors of the layers are controlled to eliminate the problem of delamination between layers.

Information processors (CPU's) are designed to have a small size and bulk storage capacity and to process rapidly a large quantity of information. Also, semiconductor devices are assembled with a high packaging density, and, as a result, are equipped with a large number of semiconductor elements such as LSI's and VLSI's densely arranged thereon.

Initially multi-layer printed circuit boards comprising, for example, a glass epoxy were used in these devices as circuit boards carrying these semiconductor elements. Recently, however, the heat generated per semiconductor chip has been found to exceed 10 W, as the integration density of semiconductor devices has increased. As a consequence, the multi-layer printed circuit boards have been replaced by ceramic substrates having a superior heat resistance.

Initially, alumina ($Al_2O_3$) ceramics were employed in the manufacture of ceramic substrates, and tungsten (W) was used as a metal material for forming patterns of wiring. The signal frequency processed by or transmitted through such a device reaches frequencies of the order of MHz, in line with the increased speed of information processing and optical communication, is already in practical use and as a result, the use of ceramic substrates having a low loss and conductive materials having a low electrical resistance is required.

In this respect, although copper (Cu) is a preferred conductive material having a low electrical resistance, it has a low melting point of the order of 1084°C, and accordingly, copper cannot be used as a material for distributing wires of a multi-layer circuit board comprising alumina ceramics, the green sheet of which requires a firing temperature of more than 1400°C.

Accordingly, glass ceramics requiring a low firing temperature are used.

More specifically, glass ceramics require a low firing temperature of the order of not more than 1000°C, and this allows the use of metallic materials such as gold (Au) and Cu having good electrical conductivities.

Typical examples of glass ceramics are composed of alumina powder and borosilicate glasses. The use of these glass ceramics is effective for the following reasons. The dielectric constant of the borosilicate glass is low, of the order of about 4, and correspondingly the combined dielectric constant of the resulting composite material ranges from 5 to 7, which is lower than that of alumina ceramics (about 10). This accordingly allows a shortening of the signal delay time.

Nevertheless, it has become necessary to reduce further the combined dielectric constant of substrates, in proportion to the increased speed of the signal transmission, and, accordingly, a part of the borosilicate glass is replaced with hollow silica powder. The use of the hollow silica powder permits a further reduction of the combined dielectric constant, since the dielectric constant of air is 1.

The mechanical strengths of glass ceramics, however, are not satisfactory; for example, the bending strength thereof is of the order of 150 to 200 Mpa, which is lower than that of alumina ceramics. The mechanical strength of the resulting glass ceramics would be further reduced if a part of the borosilicate glass component were replaced by the hollow silica powder, and accordingly, the glass ceramics would be easily damaged.

To solve this problem, i.e., to improve the mechanical strength of the resulting multi-layer glass ceramic substrate, a method has been proposed which comprises forming signal layers, which are elements of the multi-layer glass ceramic substrate and on which patterns of signal lines are formed, from a glass ceramic containing hollow silica powder, and forming other layers of the substrate, such as the uppermost and lowermost layers which do not affect the quality of a signal, from a glass ceramic free of the hollow silica powder.

In this case, however, the multi-layer glass ceramic substrate comprises layers having different compositions and this leads to the occurrence of delamination between the signal layers and the upper and lower layers of the substrate during the firing of the corresponding green sheets, due to the differences in the firing shrinkage factors of these layers having different compositions.

Accordingly, an object of the present invention is to solve this problem.

According to the present invention, there is provided a process for manufacturing a multi-layer glass ceramic substrate, comprising the steps of:

forming green sheets containing ceramic powder and glass powder components as main ingredients.

laminating the green sheets,and firing the laminated green sheets to form the multi-layer glass ceramic substrate,

in which process at least one green sheet contains a porous glass powder constituting a part of said glass powder component.

The process of the present invention is preferably one wherein said green sheets additionally contain hollow glass spheres and porous glass powder as further main ingredients, and are used to form a signal layer by

forming an interconnection layer on each of the green sheets, and

laminating the green sheets with the interconnection layer, in which process said signal layer is sandwiched between upper and lower further green sheets containing ceramic powder and glass powder as main ingredients, and said sandwiched signal layer is fired to form the multi-layer glass ceramic substrate.

In a preferred procedure a multi-layer glass ceramic substrate is manufactured by a procedure as aforesaid, in which patterns of distributing wires are formed on the green sheets and the green sheets are laminated to form a laminated signal layer. This signal layer is sandwiched between green sheets mainly comprising ceramic powders and glass powders, to unite the layers; and the united layers are fired.

In the practice of the present invention, porous glass powders are used for compensating for differences between the firing shrinkage factors of green sheets comprising glass ceramics and having different compositions.

More specifically, the porous glass powders have a highly uneven surface and thus have large surface areas and therefore, the layer containing the porous glass powders undergoes a high degree of shrinkage during the firing.

Therefore, the firing shrinkage factor of the green sheet can be adjusted by controlling the amount of the porous glass powder to be incorporated in such a manner that the shrinkage factor is increased.

Thus, the amount of porous glass powder is selected to be such that shrinkage of the first green sheets matches that of the upper and lower green sheets during the firing thereby to prevent a cracking or delamination of the upper and lower green sheets during the firing.

In the present invention, silica ($SiO_2$) is preferably used as a material for the porous glass powder, because silica has excellent electrical properties and does not suffer from a reduction of the insulation resistance and electrical dielectric breakdown resistance.

In the present invention, high purity porous glass powders obtained by the sol-gel process may be added to green sheets having low firing shrinkage factors, to form signal layers and increase the firing shrinkage factors of the green sheets forming the signal layers.

For a better understanding of the invention and to show how the same can be carried into effect, reference will now be made, by way of example only, to the accompanying drawings wherein:

Figure 1 is a diagram showing the structure of a multi-layer substrate;

Figure 2 is a diagram for explaining the principle embodied by the present invention of increasing the firing shrinkage factor of a green sheet for a signal layer;

Figure 3A is a diagram illustrating the firing of a green sheet comprising ceramic particles, glass particles having a low softening point and hollow glass micro-spheres;

Figure 3B is a diagram illustrating the firing of a green sheet comprising ceramic particles, glass particles having a low softening point, hollow glass microspheres and porous glass powder;

Figure 4 is a diagram showing the shrinkage behaviour of the green sheet prepared in Example 1;

Figures 5 and 6 are diagrams showing the shrinkage behaviour of the green sheet prepared in Example 2; and

Figure 7 is a diagram for explaining the occurrence of cracking and delamination of a conventional multi-layer ceramic substrate.

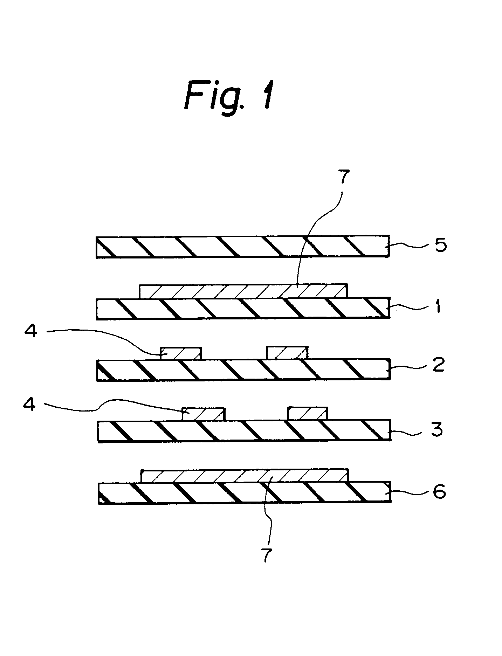

Figure 1 is an exploded cross sectional view showing the structure of a multi-layer circuit board as explained above and composed of 5 layers of green sheets.

More specifically, three layers of green sheets, i.e. first layer 1, second layer 2 and third layer 3, are formed from glass ceramic green sheets containing hollow silica spheres, with signal distributing wires 4 being patterned on the surfaces of the second and third layers of green sheets 2 and 3.

The uppermost green sheet layer 5 and lowermost green sheet layer 6 are formed from glass ceramic green sheets free of hollow silica powders, ground layers 7 being patterned between the first layer 1 and the uppermost layer 5 and between the third layer 3 and the lowermost layer 6. These layers of green sheets are then united to give a laminated green sheet, and the laminated green sheet is fired to give a multi-layer substrate having excellent transmission characteristics.

If a multi-layer glass ceramic substrate is formed from these different materials, however, delamination is liable to occur due to the difference in firing shrinkage factors of the green sheets containing hollow silica powder (the first to third layers 1 to 3) and those free of hollow silica powder (the uppermost and lowermost layers 5 and 6) and this tendency becomes even more conspicuous as the surface area of the substrate is increased.

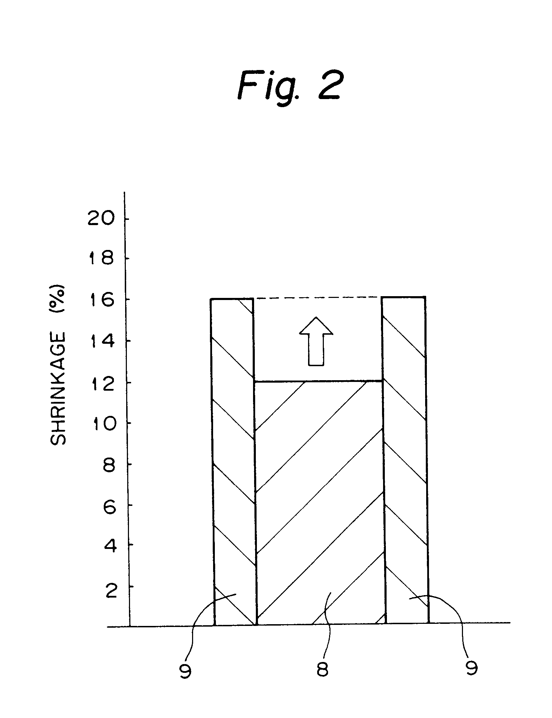

The principle of the present invention, which provides a solution to this problem, will be explained with reference to Figure 2.

A green sheet for a signal layer 8 is formed from a material principally comprising ceramic powder, glass powder and hollow glass microspheres, to reduce the dielectric constant of the glass ceramic layer formed by sintering the green sheet for the signal layer 8. The hollow glass microspheres have a particle size greater than those of the other powders, have a spherical shape, and remain as a hollow structure even at firing temperature. Therefore, the green sheets comprising the hollow glass microspheres have a low firing shrinkage factor of the order of 12%.

Glass ceramic layers 9 (hereinafter simply referred to as "reinforcing layer(s)") mainly comprising ceramic powders and glass powders, which are arranged on and below the green sheets of the signal layer 8, have high firing shrinkage factors of the order of 16%.

In the present invention, the green sheet for the signal layer 8 is formed from the foregoing conventional material, which principally comprises ceramic powder, glass powder and hollow glass microspheres and to which porous glass powder is added as an additional ingredient to increase the firing shrinkage factor to about 16% (from the conventional value of about 12%). Hence, the firing shrinkage factor is made to coincide with the value thereof for the reinforcing layers 9. As a result the problem of delamination is solved by the present invention.

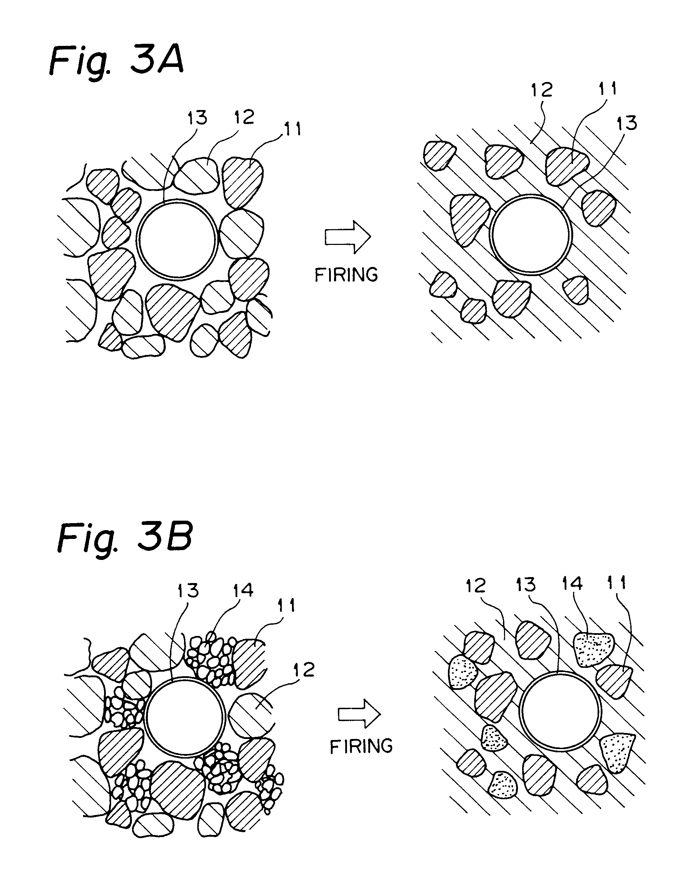

Figure 3A schematically shows how this principle operates. When a green sheet comprising alumina particles 11, borosilicate glass particles 12 and hollow glass microspheres 13 is fired, the borosilicate glass particles 12 are fused or soften to form a matrix in which the alumina particles 11 and the hollow glass microspheres 13 are dispersed. In this respect, the presence of the hollow glass microspheres 13 in the green sheet minimizes the shrinkage of the sheet.

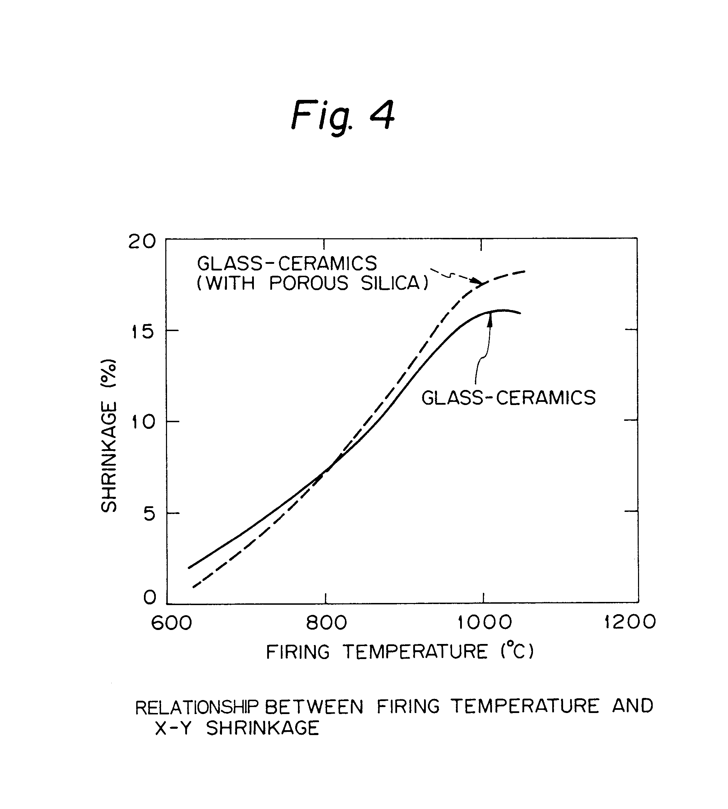

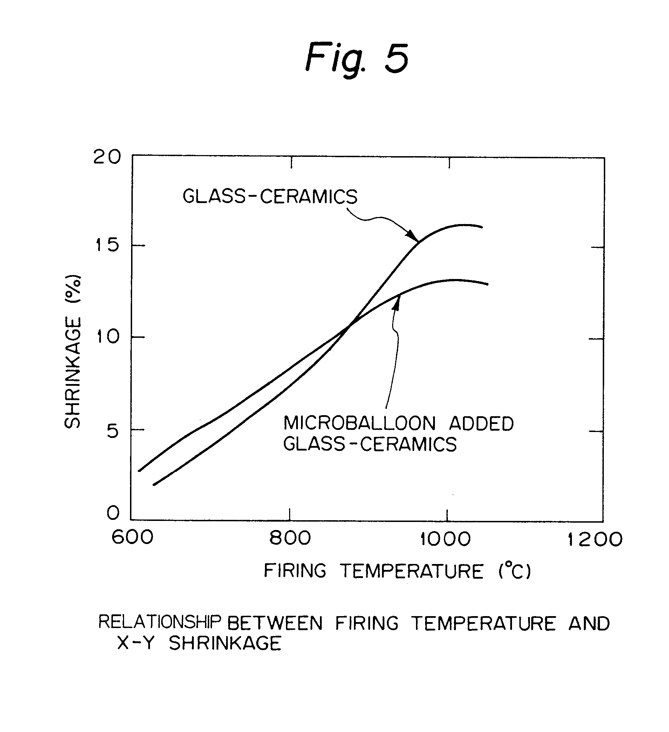

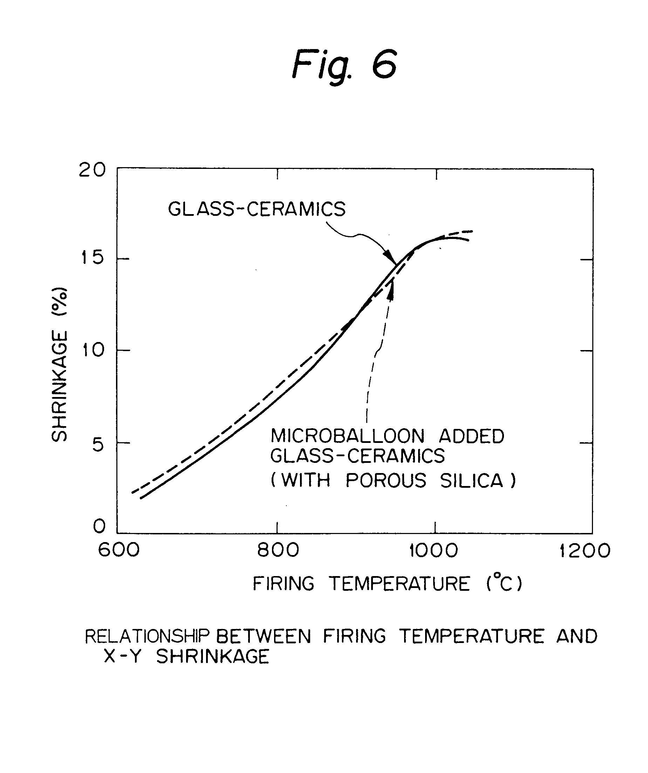

If the green sheet for the signal layer comprises porous silica particles 14 in addition to alumina particles 11, borosilicate glass particles 12 and hollow glass microspheres 13, the large shrinkage of the porous silica particles 14 suffered during firing, as shown in Figure 3B or Figure 4, can be compensated for by the low shrinkage factor of the hollow glass microspheres 13 as shown in Figure 5, and therefor the overall firing shrinkage factor of the resulting green sheet can be made to coincide with that of a green sheet comprising alumina particles 11 and borosilicate particles 12 and free of hollow fine glass spheres 13 as shown in Figure 6.

Typical examples of porous glass particles to be used in the practice of this invention include those obtained by the sol-gel method, i.e., those obtained by hydrolyzing silicone alkoxides such as tetramethoxy silicate $[Si(OCH_3)]$ and tetraethoxy silicate $[Si(OC_2H_5)_4]$, which are prepared by reacting water glass with alcohols to give hydrated oxide sols, subjecting the sols to dehydration to form gels, and then heating the gels to form amorphous $SiO_2$. The porous silica is an aggregate of the fine particles of silica and had during firing, a high shrinkage factor in relation to the pores present therein. The porous glass also can be prepared by forming a glass in which sodium is dispersed In a glass matrix,and then leaching out the sodium phase.

The ceramic particles used in the present invention are added to the green sheets to improve the mechanical strength of the resulting substrate and stabilize the glass (while also possibly preventing crystallization of the glass). Typical examples of ceramic particles are particles of alumina type such as mullite. Further, it is possible to use a glass-type material, such as silica, which is not softened at the firing temperature. The particle size of the ceramic particles is not critical in the present invention, but those having a particle size of from 2 to 3 $\mu$m are usually employed. The amount of the ceramic (alumina etc.) particles to be incorporated ranges from 10 to 70 % by weight related to the total weight of the inorganic materials for preparing the glass ceramic component of the green sheets, which particles comprise the ceramic particles or high softening point glass particles, hollow glass microspheres, glass particles and porous glass particles, with a part of the ceramic particles being replaced by hollow glass microspheres. The upper limit to the amount of the hollow glass microspheres to be incorporated is of the order of 40% by weight, based on the total weight of the inorganic materials.

The hollow glass microspheres are added to the material to reduce the dielectric constant of the resulting glass ceramic layer formed by sintering the green sheet. The size of the microspheres is preferably as small as possible, and those having a particle size of not less than 10 $\mu$m are readily available on the market.

The low softening point glass is a glass capable of being softened at a temperature of not more than the firing temperature, and a typical example thereof usable in the invention is a borosilicate glass having a softening point of about 800°C. The amount of the low softening point glass used is preferably approximately equal to half of the remaining portion of the inorganic materials (30 to 90 % by weight) other than the ceramic particles and the hollow glass microspheres and in general ranges from 15 to 50 % by weight, with the balance being made up of the porous glass powders.

Both the low softening point glass particles and the porous glass particles to be used in the invention preferably have a particle size of about 2 to 3 $\mu$m.

According to the present invention, the amount of porous glass powder to be incorporated in the inorganic material is such that the difference between the firing shrinkage factors of the green sheet comprising the ceramic particles and the low softening point glass particles and free of the hollow glass microspheres and of the green sheet comprising the ceramic particles, low softening point glass particles, hollow glass microspheres and porous glass powders is preferably not more than ± 0.5%, more preferably not more than ± 0.2%, as determined for a sheet having a size, for example of 300 mm$^2$.

It is to be noted that the dielectric constants are 10 for the alumina, 4.6 for the borosilicate glass, about 1.3 for the hollow glass microspheres and 3.8 for the porous silica respectively. A conventional glass ceramic substrate comprising alumina, borosilicate glass and silica glass has a dielectric constant of 5 to 6, and such a substrate containing additionally, hollow glass microsphere has a dielectric constant of about 4 to 2.5.

According to the method of the present invention, a multi-layer glass ceramic substrate can be manufactured by adding additives such as a binder, a solvent and/or a plasticizer to a mixture of ceramic particles, low softening point glass particles, hollow glass microspheres and porous glass powder, and kneading the resulting mixture to form a slurry; forming the slurry into green sheets (A); patterning signal distributing wires on the green sheets and laminating the green sheets to form a signal layer (B); separately forming green sheets (C) mainly comprising ceramic particles and glass particles; sandwiching the laminated signal layer (B) between upper and lower green sheets (C) to unite these layers; and then firing the resulting laminate.

The firing can be performed in a nitrogen gas atmosphere when the conductive material used is copper or in air when it is gold or an alloy of silver and palladium. More specifically, when the conductive material is copper, the firing temperature for the laminate is raised to about 850°C at a temperature elevation rate of about 50°C/hr, the temperature rise occurring in a wet nitrogen atmosphere, and the laminate is maintained at about 850°C over 4 hours. The temperature is then raised to 1000°C with the laminate blanketed by a dry nitrogen atmosphere, the temperature of the laminate is maintained at about 1000°C for 4 hours, and then the laminate is cooled.

The layers free of hollow glass microspheres arranged on and below the signal layer serve to impart mechanical strength and evenness to the resulting multi-layer substrate. Also the upper and lower surfaces of the substrate can be ground to improve the evenness thereof.

The following examples illustrate this invention:

Example 1:

(Confirmation of Improved Firing Shrinkage Factor)

The following ingredients were mixed and kneaded to form a slurry, which was subjected to a degassing and formation therefrom of a green sheet having a thickness of 300 µm by means of the doctor blade process. The slurry had the composition:

| | |
|---|---|
| Alumina powder | 100g |
| Borosilicate glass powder | 200g |
| Porous silica glass powder | 200g |
| Acetone (solvent) | 80g |
| | |
| Methyl ethyl ketone (solvent) | 350g |
| Dibutyl phthalate (plasticizer | 30g |
| Polymethyl methacrylate (binder) | 100g |

The green sheet was then formed into pieces 9 x 9 cm, by blanking, and subsequently, a copper (Cu) paste was applied to the surface thereof to form lines of conductive material by a screen printing process.

Thereafter, eight of these green sheets were stacked in layers, a pressure of 10 MPa was applied to the laminated green sheets at 80°C, to unite the same, and the united laminate was then fired at 1,000°C for 5 hours to give a multi-layer substrate.

As shown in Figure 4, the resulting substrate had a firing shrinkage factor of 18%. Namely, the firing shrinkage factor was 2% higher than that (16%) of the conventional multi-layer substrate free of the porous silica glass powder.

Example 2:

(Formation of Multi-layer Substrate Comprising a Signal layer and Reinforcing Layers)

The following ingredients were mixed and kneaded to give a slurry which was subject to a degassing. A green sheet having a thickness of 300 µm was formed by the doctor blade process from the slurry:

EP 0 508 821 A2

| | |
|---|---|
| Mullite powder | 100g |
| Borosilicate glass powder | 100g |
| Porous silica glass powder | 50g |
| Hollow silica microspheres | 50g |
| Acetone (solvent) | 80g |
| Methyl ethyl ketone (solvent) | 350g |
| Dibutyl phthalate (plasticizer) | 30g |
| Polymethyl methacrylate (binder) | 100g |

The green sheet was formed into pieces 9 x 9 cm by blanking,to give green sheets for use in producing a signal layer, and subsequently, a copper (Cu) paste was applied to the surfaces of eight of these green sheets to form lines of the conductive material, by a screen printing process.

Thereafter,the following ingredients were mixed and kneaded to give a slurry which was degassed. A green sheet having a thickness of 300 μm, when formed by the doctor blade process from the slurry:

| | |
|---|---|
| Alumina powder | 200g |
| Borosilicate glass powder | 200g |
| Silica glass powder | 200g |
| Acetone (solvent) | 80g |
| Methyl ethyl ketone (solvent) | 350g |
| Dibutyl phthalate (plasticizer) | 30g |
| Polymethyl methacrylate (binder) | 100g |

The green sheet was formed into pieces 9 x 9 cm, by blanking,to give green sheets for use as reinforcing layers.

Thereafter, one each of the green sheets for the reinforcing layer was placed as an upper or lower surface of each green sheet for the signal layer (8 sheets in all),the sheets then were stacked, a pressure of 10 MPa was applied to the resulting laminate at 80°C, to unite the laminate ad the united laminate was then fired at 1000°C for 5 hours to give a multi-layer substrate.

No cracking or delamination was observed between the reinforcing layers and the signal layers.

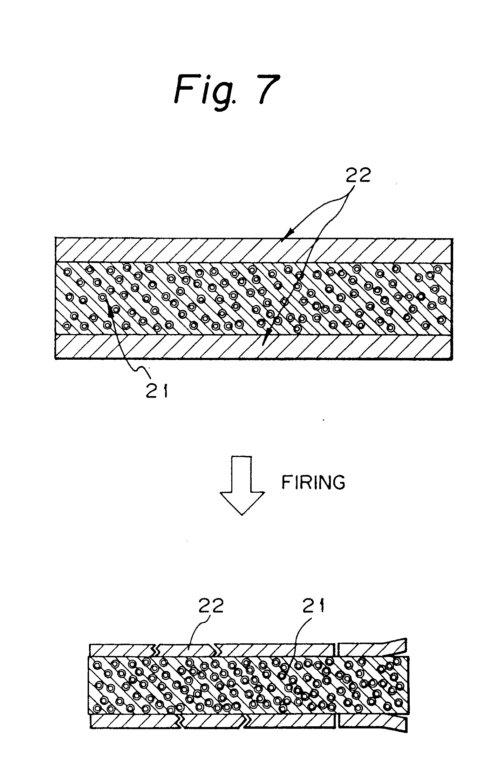

Figure 5 shows the firing shrinkage factor curves of the foregoing green sheet for the reinforcing layer and a conventional hollow silica microspheres-containing green sheet, which has the same composition as that of the foregoing green sheet for a signal layer except for replacing all of the porous silica glass powder with hollow silica microspheres. For example,the former has a firing shrinkage factor of 18% and the latter has a shrinkage factor of 13%, and hence,the difference in the firing shrinkage factors is as much as 5%. Therefore, if these green sheets are assembled together and united, the multi-layer substrate obtained after firing suffers from the problems of cracking and delamination as shown in Figure 7. In Figure 7, reference numerals 21 and 22 represent a signal layer and a reinforcing layer respectively, Figure 7 showing these layers in the green sheet state (upper) and sintered glass ceramic layer state (lower).

Figure 6 shows the firing shrinkage factor curves of a green sheet for the reinforcing layer and for the signal layer (comprising hollow silica microspheres and porous silica glass powders) obtained in the foregoing example. The curves shown in Figure 6 indicate that the shrinkage behaviour of the reinforcing layer closely matches that observed for the signal layer.

## Claims

1. A process for manufacturing a multi-layer glass ceramic substrate, comprising the steps of:

forming green sheets containing ceramic powder and glass powder components as main ingredients.

laminating the green sheets,and firing the laminated green sheets to form the multi-layer glass ceramic substrate, in which process at least one green sheet contains a porous glass powder constituting a part of said glass powder component.

2. A process according to Claim 1, wherein said porous glass powder has been made by a sol-gel method.

3. A process according to Claim 2, wherein said porous glass powder is a porous silica powder.

4. A process according to Claim 1, wherein said glass powder includes a glass powder having a low softening point and which is softened during the firing, and glass powder having a high softening point and which is not softened during the firing.

5. A process as claimed in any preceding claim, wherein said green sheets additionally contain hollow glass spheres and porous glass powder as further main ingredients, and are used to form a signal layer by

forming an interconnection layer on each of the green sheets, and

laminating the green sheets with the interconnection layer, in which process said signal layer is sandwiched between upper and lower further green sheets containing ceramic powder and glass powder as main ingredients, and said sandwiched signal layer is fired to form the multi-layer glass ceramic substrate.

6. A process according to Claim 5, wherein the amount of said porous glass powder is such that its shrinkage imparts to said green sheets used in producing said signal layer a shrinkage during firing time matching that of said upper and lower green sheets.

7. A process according to Claim 5 or 6 wherein said glass powder in said upper and lower green sheets includes glass powder having a low softening point and which is softened during the firing, and glass powder having a high softening point and which is not softened during the firing.

8. A process according to any one of Claims 5 to 7, wherein said interconnection layer is made of copper.

9. A process according to any one of Claims 5 to 8, wherein, in said signal layer, said ceramic powder is an alumina powder, said glass powder is borosilicate glass powder, said hollow glass spheres are hollow silica microspheres, and said porous glass powder is porous silica powder.

10. A process according to any preceding claim, wherein said firing is carried out at about 1000°C.

# Fig. 1

# Fig. 2

*Fig. 3A*

FIRING

*Fig. 3B*

FIRING

# Fig. 4

RELATIONSHIP BETWEEN FIRING TEMPERATURE AND
X-Y SHRINKAGE

# Fig. 5

RELATIONSHIP BETWEEN FIRING TEMPERATURE AND
X-Y SHRINKAGE

## *Fig. 6*

RELATIONSHIP BETWEEN FIRING TEMPERATURE AND X-Y SHRINKAGE

# Fig. 7

FIRING